# EUROPÄISCHE PATENTANMELDUNG

(11) **EP 2 009 973 A2**
(43) Veröffentlichungstag der Anmeldung: **31.12.2008**
(21) Anmeldenummer: 08011147.9
(22) Anmeldetag: 19.06.2008
(51) Int. Cl.: H05K 7/14

(54) **Einrichtung für die Kontrolle eines sanften Anlaufs oder Auslaufs von Drehstrommotoren, sogenannte Soft Starter**

(30) Priorität: 29.06.2007 DE 102007030344
(71) Anmelder: Siemes, Andreas, 47661 Issum (DE)
(72) Erfinder: Siemes, Andreas, 47661 Issum (DE)
(74) Vertreter: Flaig, Siegfried

(57) **Zusammenfassung**

Eine Einrichtung für die Kontrolle eines sanften Anlaufs oder Auslaufs von Drehstrommotoren (1), sog. Soft-Startern, ist zum Starten von schweren mechanischen, elektrischen oder hydraulischen Antrieben vorgesehen. Um eine Raumersparnis bei Einzel- oder Vielfach-Anordnung und eine bessere Zugänglickeit bei der Wartung zu erzielen, ist in einem Schaltschrank (2) zumindest eine Schaltzelle (3) gebildet, die zumindest den 3phasigen Leistungsblock (4), die Leistungselektronik (5) sowie Schaltschütze (6; 18) umfasst und als Einheit nach vorne leicht ausbaufähig oder umgekehrt einbaufähig und ohne Befestigung an einer Rücken- oder Seitenwand (8) des Schaltschranks (2) angeordnet ist, außerdem ist vorgesehen, dass hingegen ein an der Schaltschrankwand (2) befestigter Trennschalter (9) mit einem Sammelschienen-Anschluss (10) mittels einer steckbaren Kontaktkupplung (10a) beim Einschieben verbindbar oder beim Ausfahren lösbar ist.

## Beschreibung

Die Erfindung betrifft eine Einrichtung für die Kontrolle eines sanften Anlaufs oder Auslaufs von Drehstrommotoren (sog. Soft Starter), die zum Starten von schweren mechanischen, elektrischen oder hydraulischen Antrieben vorgeschaltet sind, wobei einzelne Baugruppen eines Leistungsblocks mit Thyristoren, einer Leistungselektronik sowie mit Schaltschützen in einem Schaltschrank zusammengefasst sind.

Derartige Einrichtungen arbeiten im Leistungsbereich von ca. 0,5 kW , insbesondere 200 kW bis ca. 25000 kW und bei Bemessungsspannungen bis zu ca. 17,5 kV und Strömen bis zu ca. 1250 Ampere.

Aus einem Prospekt der Fa. Siemens "soft starter", insbesondere Seite 3, ist die Bauweise solcher Einrichtungen als Schaltschrank bekannt. Die Nachteile dieser Bauweise besteht jedoch in der Anordnung eines oder mehrerer Schaltschränke in Reihe und in der Gestaltung im Inneren des einzelnen Schaltschrankes. So wird in dem bekannten Schaltschrank die Leistungselektronik L1, L2 und L3 an der Rückwand starr befestigt. Die Leistungseinheit besteht aus pro Phase je einem Block von Thyristoren mit zwischen geschalteten Kühlkörpern, einer Schutzbeschaltung und einer elektronischen Ansteuerung für die Thyristoren. Im Hinblick auf die Befestigung solcher Leistungselektronik an der Rückwand werden die Anschlüsse für den Hauptstrom (die Leistung) nur von oben oder unten oder von oben und unten ausgeführt. In praktischen Fällen ergibt sich ein Mindestabstand (von ca. 120 mm) je nach Spannungsebene. Solche Schaltschränke können nur einzeln aufgestellt werden. Eine Reihe aus solchen Schaltschränken würde nachteilig einen großen Raum belegen, der anderweitig nicht genutzt werden kann. Solche Schaltschränke können nur einzeln aufgestellt werden. Eine Reihe nebeneinander aufgestellter Schaltschränke nähme nachteilig einen großen Raum in Anspruch. Daraus folgt ein enormer Platzbedarf für die weiteren zum Stromkreis des Soft-Starters erforderlichen Bauteile und Baugruppen.

Die Funktionsweise eines solchen Soft Starters ist auch aus der WO 2006 / 034977 A1 bekannt. Auf die dortige Beschreibung wird Bezug genommen.

Der Erfindung liegt die Aufgabe zugrunde, wesentliche Bauteile und Baugruppen, wie den Netz-Schaltschütz, die Leistungselektroniken L1, L2 und L3 sowie den Überbrückungs-Schaltschütz sowohl für eine Einzel- als auch eine Reihenaufstellung des Schaltschranks bzw. der Schaltzellen unterschiedlicher Leistungsstufen mit einer verbesserten Raumaufteilung unter Berücksichtigung besonderer Wartungsbedingungen anzuordnen.

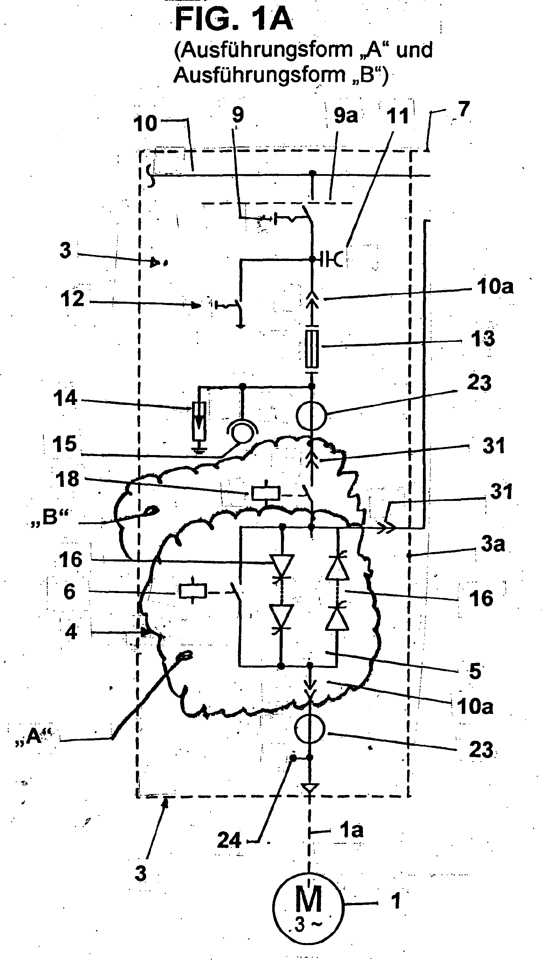

Die gestellte Aufgabe wird erfindungsgemäß dadurch gelöst, dass in einem Schaltschrank zumindest eine Schaltzelle gebildet ist, die zumindest den 3phasigen Leistungsblock, die zugehörige Leistungselektronik sowie die erforderlichen Schaltschütze umfasst und in einem Rahmen mit umgebenden Schaltzellenwänden und einer Befestigung von in Ausbaurichtung verlaufenden Stützisolatoren als Einheit nach vorne leicht ausbaufähig oder umgekehrt einbaufähig und ohne Befestigung an einer Rücken- oder Seitenwand des Schaltschranks angeordnet ist und dass hingegen ein an der Schaltschrankwand befestigter Trennschalter mit einem Sammelschienen-Anschluss mittels einer steckbaren Kontaktkupplung beim Einschieben verbindbar oder beim Ausfahren lösbar ist (Ausführungsform "A" / Fig. 1A). Die Vorteile sind eine leichte und sichere Wartungsmöglichkeit außerhalb des Schaltschranks und eine günstigere Raumaufteilung insoweit als die Breite des Schaltschranks insgesamt vermindert wird und daher eine geringere Breite bei einem einzelnen und mit der Anzahl der aneinander gereihten Schaltschränke wachsendem Raumgewinn entsteht. Der Leistungsblock (pro Phase) mit zugehörigen Bauelementen wird demzufolge ohne Befestigung an der Rückwand oder den Seitenwänden des Schaltschranks zusammengefasst bzw. angeordnet. Im Vergleich zu der bisher bekannten Ausführungsform ist diese Zusammenfassung der Bauteile zu einem Leistungsblock nur möglich, wenn die Leistungselektronik wie bekannt nicht mit der die Leistungselektronik konstruktiv tragenden Rückwand zur Schaltschrank-Rückwand eingebaut wird. Bei dem der Erfindung zugrunde liegenden Leistungsblock werden die drei Leistungselektroniken (je Phase ein Stück) in Isolierstoffkörpern aus gegenüber der bekannten Bauweise um 180° verdreht jeweils mit der tragenden glasfaserverstärkten Rückwand zur Schaltschrankfront hin, in den Rahmen eingebaut und an Traversen befestigt. Bei einer solchen Einbaulage der Leistungselektronik im Leistungsblock können einer oder mehrere den Hauptstrom führenden Anschlüsse durch die tragende glasfaserverstärkten Rückwände von der Leistungselektronik oder an oben und unten an der Rückwand vorbei zu davor befindlichen Überbrückungs-Schaltschützen bzw. zu einem Haupt-Schaltschütz geführt werden. Um mit den den Hauptstrom führenden Leitern bzw. Kupfer-Stromschienen vom Überbrückungs-Schaltschütz den Motoranschluss erreichen zu können, ist die Nutzung eines Aluminium-Kühlkörpers als leitendes Verbindungsglied in der Leistungselektronik vorteilhaft. Die bekannten Schaltschränke können aufgrund der Erfindung bis zu 50% schmaler gebaut werden.

In Ausgestaltung ist vorgesehen, dass in dem Rahmen der Schaltzelle zusätzlich ein Haupt-Schaltschütz und eine lösbare Kontaktschraubverbindung vorgesehen sind (Ausführungsform "B" / FIG. 1A). Dadurch wird eine erweiterte Baueinheit erreicht, ohne die äußeren Abmessungen zu verändern, d.h. es wird nur ein Mindestraum benötigt.

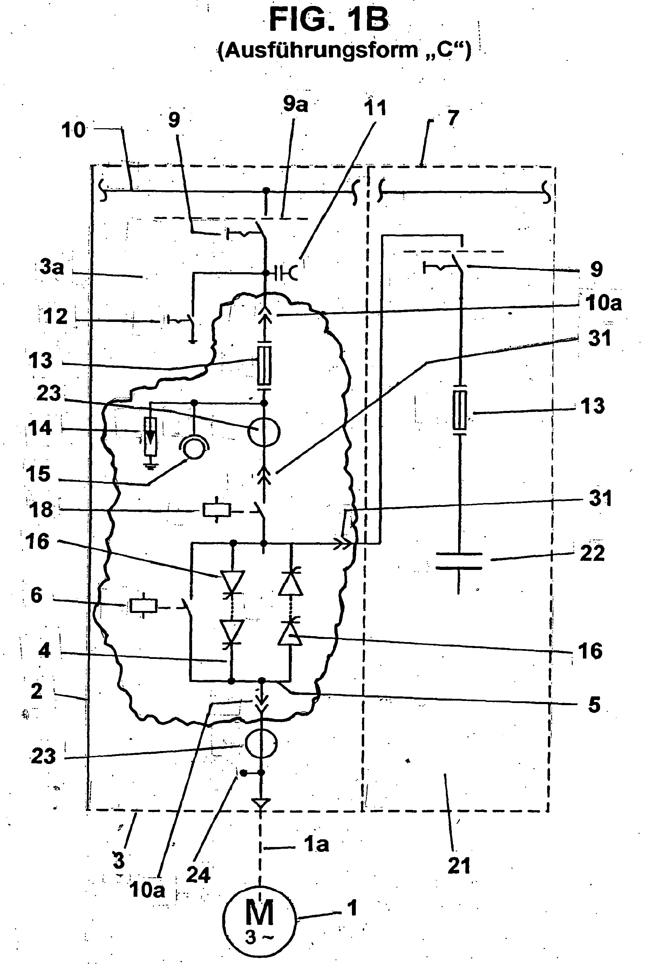

Eine noch umfangreichere Ausstattung, ebenfalls ohne äußere Veränderungen, entsteht nach weiteren Merkmalen dadurch, dass in dem Rahmen der Schaltzelle zusätzlich in den 3phasigen Motorleitungen einzelne oder doppelte Sicherungen, Überspannungsableiter und Spannungssensoren und/ oder Stromsensoren angeordnet sind und dass jeweils ein an der Schaltschrankwand befestigter Sammelschienen-Anschluss mittels einer zweiten steckbaren Kontaktkupplung verbindbar oder lösbar ist (Ausführungsform "C" / FIG. 1 B).

Der Einbau oder Ausbau der Schaltzelle ist besonders einfach und in kurzer Zeit zu bewerkstelligen, wenn nach weiteren Merkmalen zumindest die Leistungselektronik in einem aus dem Schaltschrank einfahrbaren oder ausfahrbaren Wagen angeordnet ist und in einem solchen Fall der Leistungsblock ortsfest gehalten ist.

Die komplette Schaltzelle kann aber auch von allen Seiten leicht zugänglich gewartet werden, wenn auf dem Wagen neben der Leistungselektronik auch der Leistungsblock im Betriebsabstand angeordnet ist.

Von Vorteil ist auch, dass zumindest eine Rückwand für die Leistungselektronik auf dem Wagen aus glasfaserverstärktem Kunststoff gebildet ist.

Weitere Schutzmaßnahmen für die Anordnung der Leistungselektronik und den Leistungsblock bestehen darin, dass in dem Wagenrahmen für den Leistungsblock und für die Leistungselektronik ein geschlossenes, isoliertes für jede Phase gebildet ist und dass die Stromschiene für den Anschluss der externen Motorleitungen außerhalb dieses Gehäuses verläuft und mittels Stützisolatoren an der hinteren Schaltschrankwand befestigt ist.

Eine Verbesserung besteht ferner darin, dass zwischen einer entfernbaren Isolierstoffplatte und offenen Kontakten des Trennschalters und einem nachgeordneten Netz-Schaltschütz für jede Phase eine Doppel-Sicherung geschaltet ist.

Außerdem ist vorgesehen, dass vor dem Ausgang der 3phasigen Leitung aus dem isolierten Gehäuse ein Erdungsbolzen geschaltet ist.

Nach anderen Merkmalen wird vorgeschlagen, dass der Leistungsblock im unteren Bereich mit dem Überbrückungs-Schaltschütz und im oberen Bereich mit dem Schaltschütz verbunden ist.

Für eine erweiterte Ausführungsform ist an dem Leistungsblock eine lösbare Kontaktschraubverbindung für einen Kondensator vorgesehen.

Eine andere Weiterbildung sieht vor, dass der Überbrückungs-Schaltschütz jeweils mittels den elektrischen Hauptstrom führenden Kupfer-Stromschienen im Leistungsblock an Aluminium-Kühlkörper der Leistungselektronik angeschlossen ist, die über die Kontaktkupplung mit der Stromschiene für den Motoranschluss verbindbar sind. Dadurch können unterschiedliche Ausführungen der Schaltzellen leicht berücksichtigt werden.

Die Erfindung betrifft außerdem Sicherheitsaspekte bei der Bedienung der Einrichtung und gestaltet diese weiter dadurch aus, dass der Trennschalter mittels einer Welle und der Erdungsschalter ebenfalls mittels einer Welle von außen am Schaltschrank betätigbar sind.

Außerordentlich wichtige Merkmale ergeben sich noch daraus, dass bei geöffnetem Trennschalter und bei geschlossenem Erdungsschalter und bei eingeschobener Isolierstoffplatte die Tür des Mittelspannungs-Raums öffenbar ist. Damit ist eine absolute Berührungssicherheit für den Bediener gegeben, die den einschlägigen Vorschriften der Elektrotechnik entspricht.

In der Zeichnung sind Ausführungsbeispiele der Erfindung dargestellt, die nachfolgend näher erläutert werden.

Es zeigen:
- Fig. 1A: eine elektrische Grundschaltung mit den wesentlichen Baugruppen der Erfindung für die Ausführungsformen "A" und "B",
- Fig. 1B: eine Abwandlung der in der Fig. 1A zugrundeliegenden Ausführungsform, als Ausführungsform "C",
- Fig. 2: eine perspektivische Ansicht der auszubauenden oder einzubauenden Einheit sowie mit dem bei Ausbau am Schaltschrank verbleibenden Trennschalter und dem ebenfalls verbleibenden Motoranschluss,
- Fig. 3: eine der Fig. 2 entsprechende Seitenansicht in der Ebene,
- Fig. 4: eine Vorderansicht zu den Fig. 2 und 3 und
- Fig. 5: eine perspektivische Darstellung des Schaltschranks bzw. der Schaltzelle ohne Türen an der Frontseite mit den Betätigungselementen und dem Niederspannungs- bzw. Mittelspannungs-Raum.

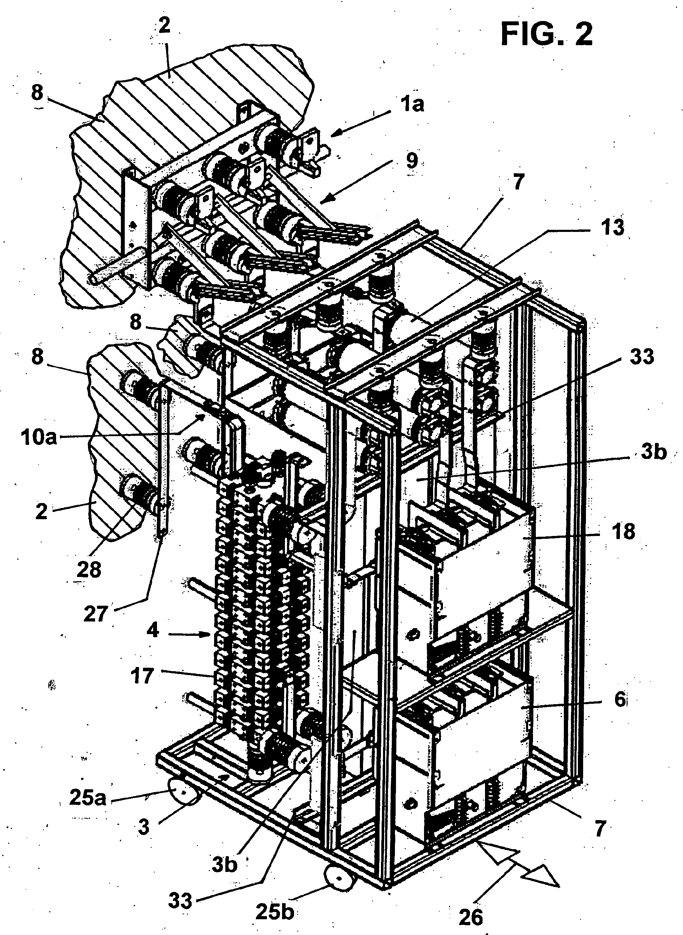

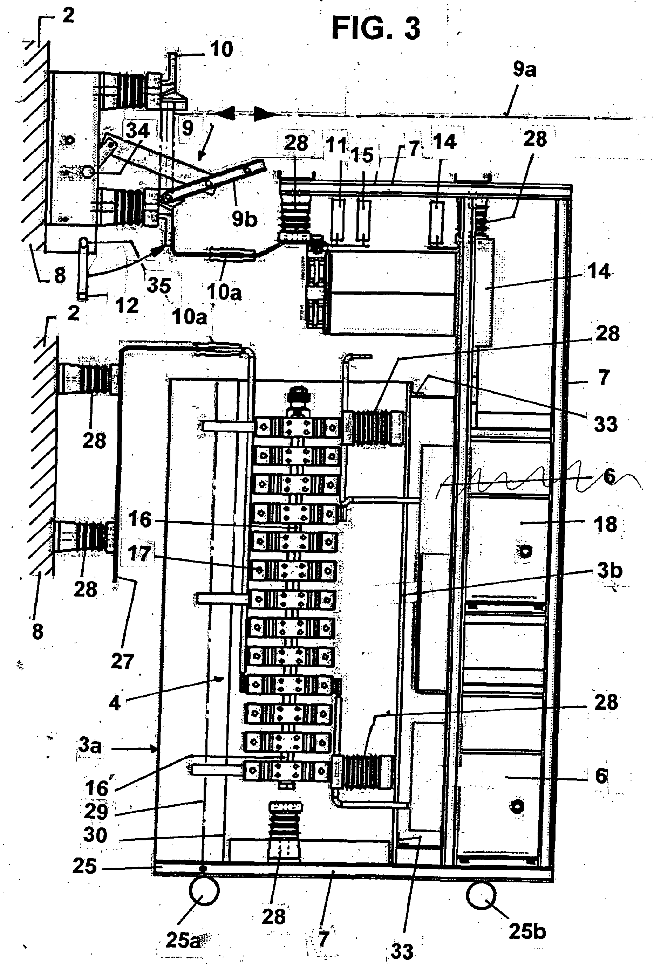

Gemäß Fig. 1A ist an einem Schaltschrank 2 der sanft anzulassende Drehstrommotor 1 über eine entsprechende geführte 3phasige Leitung 1a angeschlossen. Im Schaltschrank 2 ist eine Schaltzelle 3 mit allen wesentlichen Baugruppen, nämlich einem (noch zu erläuternden) Leistungsblock 4, bestehend aus mehreren Leistungselektroniken 5, einer elektronischen Ansteuerung 29 und einer Schutzbeschaltung 30 (Fig. 3) für Thyristoren 16 sowie einen Überbrückungs-Schaltschütz 6 gebildet, die einen nach Ausbau offen zugänglichen Rahmen 7 aufweist. Der Rahmen 7 besitzt funktionstechnisch eine Rücken- oder Seitenwand 8 (Fig. 2). Der Stromkreis kann mit einem Erdungsschalter 12 geerdet werden. Zwischen die offenen Kontakte des Trennschalters 9 wird von außen eine Isolierstoffplatte 9a durch den Schlitz 36 (Fig. 3) eingeschoben. Die elektrischen Elemente können mittels des Trennschalters 9, der aus einer (strichpunktiert gezeichneten) Isolierstoffplatte 9a mit der Breite des Schlitzes 36 besteht, von außen per Hand abgeschaltet oder eingeschaltet werden. Im Bereich des Trennschalters 9 befindet sich ein Sammelschienen-Anschluss 10 und in Aufeinanderfolge eine kapazitive Spannungsanzeige 11, die eine Erdung 12 aufweist. Außerdem sind Sicherungen 13 vorgesehen. Danach folgt ein Überspannungsableiter 14. Daran angeschlossen sind Spannungssensoren 15. Vor dem Leistungsblock 4, der aus den Thyristoren 16 mit zwischengelegten Aluminium-Kühlplatten 17 gebildet ist (vgl. Fig. 2 bis 4), ist der Haupt-Schaltschütz 18 geschaltet. Letzterer befindet sich in einem Kondensator-Bedienungsfeld 21 und ist vor einem Kondensator 22 mittels doppelten Sicherungen 13 geschützt. In der Schaltzelle 3 des variablen Soft-Starters ist in Pfeilrichtung nach dem Leistungsblock 4 der Stromsensor 23 eingezeichnet. Der Stromsensor 23 kann auch zwischen den Sicherungen 13 und dem Haupt-Schaltschütz 18 angeordnet werden. Vor dem Ausgang ist die 3phasige Leitung 1a mittels eines Erdungsbolzens 24 abgesichert.
Die Ausführungsform "A" zeigt in Dreifach-Nebeneinander-Anordnung jeweils ein an vier Seiten umschlossenes, oben und unten zur Kühlung offenes Gehäuse aus glasfaserverstärktem Kunststoff, das folgende Bauteile umschließt: die Leistungselektronik 5, die Thyristoren 16, die elektronische Ansteuerung 29 für die Thyristoren 16, die Schutzbeschaltung 30 für die Thyristoren 16, einen Überbrückungsschaltschütz 6 eine Kontaktkupplung 10a und eine lösbare Kontaktschraubverbindung 31.

In FIG. 1A ist außerdem die Ausführungsform "B" enthalten, die sich durch Ergänzung des Haupt-Schaltschützes 18 und einer lösbaren Kontaktschraubverbindung 31 ergibt.

In Fig. 1B ist zu Fig. 1A eine alternative Ausführungsform "C" dargestellt. Diese unterscheidet sich durch die Erweiterung von Bauteilen, die sich innerhalb der Schaltzelle 3 befinden, also bei Bedarf eingebaut und mit ausgefahren werden. Im wesentlichen sind diese die Doppelsicherungen 13, die lösbare Kontaktschraubverbindung 31, oder zwei weitere Kontaktkupplungen 10a sowie die Überspannungsableiter 14 und die Spannungssensoren 15. Die höher liegenden Bauteile (bspw. 11, 12 usw.) sind ohnehin fest und gehören zur Baugruppe des nicht ausbaufähigen Trennschalters 9. Diese Ausführungsform "C" zeigt wiederum in Dreifach-Nebeneinander-Anordnung jeweils das an vier Seiten umschlossene, oben und unten zur Kühlung offene Gehäuse aus glasfaserverstärktem Kunststoff, das folgende Bauteile umschließt: Die Leistungselektronik 5, die Thyristoren 16, die elektronische Ansteuerung 29, die Schutzbeschaltung 30 für die Thyristoren 16, den Überbrückungs-Schaltschütz 6, die Kontaktkupplung 10a, einen Haupt-Schaltschütz 18 und eine lösbare Kontaktschraubverbindung 31.

Gemäß Fig. 2 ist die Schaltzelle 3 gestützt durch einen Rahmen 7 als Wagen 25 ausgeführt und auf Radpaaren 25a, 25b aus dem und in den Schaltschrank 2 in Pfeilrichtungen 26 verfahrbar. Der Trennschalter 9 ist für die 3phasige Leitung 1a fest am Schaltschrank 2 angeordnet. Ebenso fest und starr ist die Stromschiene 27 für den Motoranschluss mittels Stützisolatoren 28 am Schaltschrank 2 und zwar an dessen Rück- oder Seitenwand 8 befestigt. Solche Isolierhalter 28 sind am ganzen Schaltzellen-Aggregat 3 zur Befestigung der Stromleiter vorgesehen.

In Fig. 3 sind die Baugruppen aus Fig. 2 in der Ebene von der Seite gesehen, wobei wiederum der am Schaltschrank 2, d.h. an dessen Rücken- oder Seitenwand 8, befestigte Trennschalter 9 (mit der dort nicht gezeichneten Schaltwelle 34 als Handschaltelement, das durch den Schaltschrank 2 hindurch nach außen geführt ist) und die Stromschiene 27 für den Anschluss des anzulassenden Drehstrommotors 1 sichtbar sind. Der Trennschalter 9 ist in Offenstellung gezeichnet.
Der Rahmen 7 als Träger für die eigentliche Schaltzelle 3 ist in Ausbildung als Wagen 25 mit den Radpaaren 25a, 25b mittels den jeweiligen Kontaktkupplungen 10a sowohl von der Stromschiene 27 als auch vom Trennschalter 9 auskuppelbar und wird zur Wartung vor den Schaltschrank 2 gefahren und nach erfolgtem Service wieder zurück und über die Kontaktkupplungen 10a erneut verbunden. Anstelle des Wagens 25 kann auch eine jeweils seitlich angeordnete Parallelogramm-Hebelanordnung zum Ausschwenken der Schaltzelle 3 aus dem Schaltschrank 2 und zum Wiedereinschwenken eingesetzt werden.
Zwischen den aufgereihten Thyristoren 16 befinden sich jeweils Aluminium-Kühlplatten 17. Vor den senkrecht auf einer Achse aufgereihten Thyristoren 16 sind die elektronische Ansteuerung 29 für die Thyristoren 16 und die Schutzbeschaltung 30 für die Thyristoren 16 vorgesehen. Diese befinden sich innerhalb des Leistungsblocks 4. Der Überspannungsableiter 14 gehört zur Schaltzelle 3. Am Trennschalter 9 ist für jede Phase der Sammelschienen-Anschluss 10 sichtbar. Diese Ausführungsform "C" ist wiederum durch die Dreifach-Nebeneiriander-Anordnüng des an vier Seiten umschließenden, oben und unten offenen Gehäuses aus glasfaserverstärktem Kunststoff gekennzeichnet, das folgende Bauteile umschließt: Die Leistungselektronik 5, die Thyristoren 16, die elektronische Ansteuerung 29 für die Thyristoren, die Schutzbeschaltung 30 für die Thyristoren, den Überbrückungs-Schaltschütz 6, die Kontaktkupplung 10a, den Haupt-Schaltschütz 18, eine doppelte Sicherung 13, einen Überspannungsableiter 14, einen Spannungssensor 15, eine (kapazitive) Spannungsanzeige 11, Stützisolatoren 28 und eine weitere Kontaktkupplung 10a.

Die Schaltschütze 6, 18 können auch durch Leistungsschalter unter Beibehaltung der räumlichen Anordnung im Leistungsblock 4 ersetzt werden.

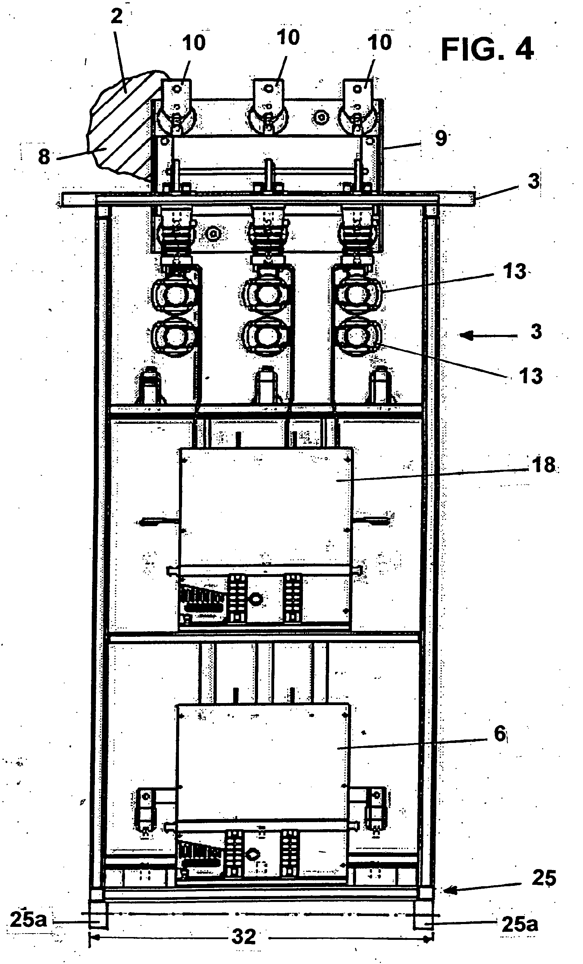

Fig. 4 zeigt den Schaltschrank 2 in oder entgegengesetzt (parallel) zur Fahrtrichtung in den Pfeilrichtungen 26. Die in den Fig. 1A bis 3 gezeigten Bauteile sind demnach bereits sichtbar und beschrieben. Aus Fig. 4 wird jedoch deutlich, dass die Schaltzelle 3 als Wagen 25 eine nur geringe Breite 32 aufweist, weil der Raumbedarf durch günstige Anordnung aller Aggregate erheblich verringert werden konnte. Innerhalb des Schaltschranks 2 befindet sich an der Rückenwand 8 nur der befestigte Trennschalter 9 mit den Sammelschienen-Anschlüssen 10 für die drei Phasen. Innerhalb der Schaltzellenbreite 32 ist der Schaltzellenrahmen 3a die größte Breitenabmessung. Die Schaltzelle 3 nimmt darin die doppelten Sicherungen 13 auf.

Darunter befindet sich der Leistungsblock 4 (nicht sichtbar) und davor angeordnet ein Schaltschütz 6 bzw. ein Überbrückungs-Schaltschütz 6, 18 als Haupt-Schaltschütz (vgl. auch Fig. 1A, 1B und Fig. 2). Die Schaltzelle 3 ist hier als Wagen 25 ausgeführt und besitzt die Radpaare 25a und 25b. Bisherige Schaltschränke 2 können aufgrund der Erfindung mit bis zu 50% Raumersparnis gebaut werden.

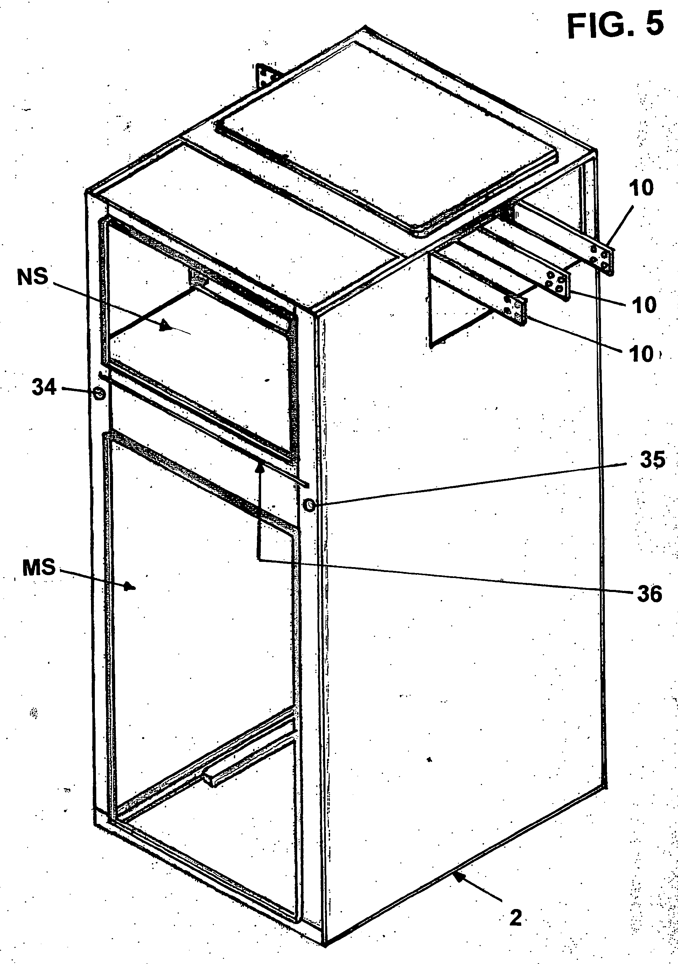

In Fig. 5 ist der Schaltschrank 2 von außen überschaubar , wobei die Sammelschienen-Anschlüsse 10 der Stromversorgung nach rechts herausragen. Weiter ist die Welle 34 für die Betätigung des Trennschalters 9 (in Fig. 3 im Inneren befindlich) nach außen geführt und kann von dort aus betätigt werden. Ebenso ist eine Welle 35 für den Erdungsschalter 12 nach außen geführt und kann ebenfalls von dort aus betätigt werden. Eine Sicherung gegen unbeabsichtigtes Schließen des Trennschalters 9 mittels der Isolierstoffplatte 9a (Fig. 3) erfolgt dadurch, dass die Isolierstoffplatte 9a durch den Schlitz 36 verläuft und zwischen die offenen Kontakte des Trennschalters 9 geschoben wird. In Fig. 3 ist ein Schaltmesser 9b in Schließstellung strichpunktiert gezeichnet. Der Bereich des Trennschalters 9 bildet einen Niederspannungs-Raum NS. Für die Aufnahme der Steuerung ist der Raum NS hermetisch durch Blechwände von dem Bereich eines Mittelspannungs-Raums MS getrennt, d.h. geschottet. Letzterer dient für die Aufnahme der zum Hauptstromkreis gehörenden Bauteile (vgl. die Fig. 1A, 1B, Fig. 3 und Fig. 4).

Wie in den Fig. 3 und 5 gezeigt ist, verlaufen im oberen Teil des Mittelspannungs-Raums MS hinter dem Niederspannungs-Raum NS ortsfest eingebaut die 3phasigen Sammelschienen, die die drei Schaltzellen 3 miteinander verbinden. Die Sammelschienen sind auf den 3phasigen, an der rückwärtigen Schaltzellenwand 3a ortsfest eingebauten Trennschalter 9 geführt. Unter dem Trennschalter 9 ist der Erdungsschalter 12 ortsfest an der Rückenwand 8 des Schaltschranks 2 montiert. Der Erdungsschalter 12 ist mechanisch gegen den Trennschalter 9 verriegelt. Demzufolge kann der Erdungsschalter 12 über einen Bedienhebel (in Fig. 3 gezeichnet) auf der Welle 34 an der Frontseite des Schaltschranks 2 nur eingeschaltet werden, wenn der Trennschalter 9 ausgeschaltet wird (= offen ist, ausgezogen gezeichnet). Anderweitig kann der Trennschalter 9 nur eingeschaltet werden, wenn der Erdungsschalter 12 ausgeschaltet, d.h. offen ist. Das Öffnen der Tür vor dem Mittelspannungs-Raum MS ist ebenfalls mechanisch verriegelbar. Im ausgeschalteten Zustand des Trennschalters 9 steckt der Bediener durch den Schlitz 36 an der Frontseite des Schaltschranks 2 die Isolierstoffplatte 9a tief in die Schaltzelle 3 bis in die offenen Kontakte des Trennschalters 9. Erst nach dem Öffnen des Trennschalters 9, dem Schließen des Erdungsschalters 12 und dem Einschieben der Isolierstoffplatte 9a kann der Bediener die Tür zum Mittelspannungs-Raum MS öffnen. Diese mechanischen Verriegelungen gewährleisten für den Bediener, dass keine Fehlbedienungen entstehen. Der Zustand wird durch die visuelle und sichere Trennstrecke der zur Spannung führenden Sammelschiene, den geerdeten Zustand der Bauteile im Mittelspannungs-Raum MS der Schaltzelle 3 unterhalb des Trennschalters 9 gewährleistet.

### Bezugszeichenliste

- 1: Drehstrommotor
- 1 a: 3phasige Motorleitung
- 2: Schaltschrank(wand)
- 3: Schaltzelle
- 3a: Schaltzellenwand
- 3b: Rückwand für die Leistungselektronik
- 4: Leistungsblock
- 5: Leistungselektronik
- 6: Überbrückungs-Schaltschütz
- 7: Rahmen
- 8: Rücken- oder Seitenwand des Schaltschranks
- 9: Trennschalter
- 9a: Isolierstoffplatte
- 9b: Schaltmesser
- 10: Sammelschienen-Anschluss
- 10a: Kontaktkupplung
- 11: (kapazitive) Spannungsanzeige
- 12: Erdungsschalter
- 13: Sicherung, einzeln oder doppelt
- 14: Überspannungsableiter
- 15: Spannungssensor
- 16: Thyristoren (Hochleistungs-Thyristoren)
- 17: Aluminium-Kühlkörper
- 18: Haupt-Schaltschütz
- 19:
- 20:
- 21: Schaltzelle für Blindstrom-Kompensation
- 22: Kondensator
- 23: Stromsensor
- 24: Erdungsbolzen
- 25: Wagen (mit Rahmen)
- 25a: Radpaar
- 25b: Radpaar
- 26: Pfeilrichtungen
- 27: Stromschiene für den Motoranschluss
- 28: Stützisolator
- 29: elektronische Ansteuerung für die Thyristoren
- 30: Schutzbeschaltung für die Thyristoren
- 31: lösbare Kontaktschraubverbindung
- 32: Fahrwagenbreite
- 33: Traversen
- 34: Welle für Trennschalter
- 35: Welle für Erdungsschalter
- 36: Schlitz für Isolierstoffplatte
- NS: Niederspannungs-Raum
- MS: Mittelspannungs-Raum

## Patentansprüche

1. Einrichtung für die Kontrolle eines sanften Anlaufs oder Auslaufs von Drehstrommotoren (1) (sog. Softstarter), die zum Starten von schweren mechanischen, elektrischen oder hydraulischen Antrieben vorgeschaltet sind, wobei einzelne Baugruppen eines Leistungsblocks (4) mit Thyristoren (16), einer Leistungselektronik (5) sowie mit Schaltschützen in einem Schaltschrank (2) zusammengefasst sind,
**dadurch gekennzeichnet,**
**dass** in einem Schaltschrank (2) zumindest eine Schaltzelle (3) gebildet ist, die zumindest den 3phasigen Leistungsblock (4), die zugehörige Leistungselektronik (5) sowie die erforderlichen Schaltschütze umfasst und in einem Rahmen (7) mit umgebenden Schaltzellenwänden (3b) und einer Befestigung von in Ausbaurichtung (26) verlaufenden Stützisolatoren (28) als Einheit nach vorne leicht ausbaufähig oder umgekehrt einbaufähig und ohne Befestigung an einer Rücken- oder Seitenwand (8) des Schaltschranks (2) vorgesehen ist und dass hingegen ein an der Schaltschrankwand (2) befestigter Trennschalter (9) mit einem Sammelschienen-Anschluss (10) mittels einer steckbaren Kontaktkupplung (10a) beim Einschieben verbindbar oder beim Ausfahren lösbar ist (Ausführungsform "A" / Fig. 1 A).

2. Einrichtung nach Anspruch 1,
**dadurch gekennzeichnet,**
**dass** in dem Rahmen (7) der Schaltzelle (3) zusätzlich ein Haupt-Schaltschütz (18) und eine lösbare Kontaktschraubverbindung (31) vorgesehen sind (Ausführungsform "B" / Fig. 1A).

3. Einrichtung nach den Ansprüchen 1 und 2,
**dadurch gekennzeichnet,**
**dass** in dem Rahmen (7) der Schaltzelle (3) zusätzlich in den 3phasigen Motorleitungen (1a) einzelne oder doppelte Sicherungen (13), Überspannungsableiter (14) und Spannungssensoren (15) und / oder Stromsensoren (23) angeordnet sind und dass jeweils ein an der Schaltschrankwand (2) befestigter Sammelschienen-Anschluss (10) mittels einer zweiten steckbaren Kontaktkupplung (10a) verbindbar oder lösbar ist (Ausführungsform "C" / Fig. 1 B).

4. Einrichtung nach Anspruch 1,
**dadurch gekennzeichnet,**
**dass** zumindest die Leistungselektronik (5) in einem aus dem Schaltschrank (2) einfahrbaren oder ausfahrbaren Wagen (25) angeordnet ist und in einem solchen Fall der Leistungsblock (4) ortsfest gehalten ist.

5. Einrichtung nach Anspruch 1 bis 3,
**dadurch gekennzeichnet,**
**dass** auf dem Wagen (25) neben der Leistungselektronik (5) auch der Leistungsblock (4) im Betriebsabstand angeordnet ist.

6. Einrichtung nach einem der Ansprüche 3 bis 5,
**dadurch gekennzeichnet,**
**dass** zumindest die Rückwand (3b) des Wagens (25) für die Leistungselektronik (5) aus glasfaserverstärktem Kunststoff gebildet ist.

7. Einrichtung nach einem der Ansprüche 4 bis 6,
**dadurch gekennzeichnet,**
**dass** in dem Wagenrahmen (25) für die Leistungselektronik (5) und für den Leistungsblock (4) ein geschlossenes, isoliertes Gehäuse für jede Phase gebildet ist und dass die Stromschiene (27) für den Anschluss der externen Motorleitungen außerhalb dieses Gehäuses verläuft und mittels Stützisolatoren (28) an der hinteren Schaltschrankwand (2) befestigt ist.

8. Einrichtung nach einem der Ansprüche 1 bis 5,
**dadurch gekennzeichnet,**
**dass** zwischen einer entfernbaren Isolierstoffplatte (9a) und offenen Kontakten des Trennschalters (9) und einem nachgeordneten Netz-Schaltschütz für jede Phase eine Doppel-Sicherung (13) geschaltet ist.

9. Einrichtung nach einem der Ansprüche 1 bis 5,
**dadurch gekennzeichnet,**
**dass** vor dem Ausgang der 3phasigen Leitung (1 a) aus dem isolierten Gehäuse ein Erdungsbolzen (24) geschaltet ist.

10. Einrichtung nach einem der Ansprüche 1 bis 4,
**dadurch gekennzeichnet,**
**dass** der Leistungsblock (4) im unteren Bereich mit dem Überbrückungs-Schaltschütz (6) und im oberen Bereich mit dem Haupt-Schaltschütz (18) verbunden ist.

11. Einrichtung nach einem der Ansprüche 1 bis 5,
**dadurch gekennzeichnet,**
**dass** an dem Leistungsblock (4) eine lösbare Kontaktschraubverbindung (31) für einen Kondensator (22) vorgesehen ist.

12. Einrichtung nach den Ansprüchen 1 bis 11,
**dadurch gekennzeichnet,**
**dass** der Überbrückungs-Schaltschütz (6) jeweils mittels den elektrischen Hauptstrom führenden Kupfer-Stromschienen im Leistungsblock (4) an Aluminium-Kühlkörper (17) der Leistungselektronik (5) angeschlossen ist, die über die Kontaktkupplung (10a) mit der Stromschiene (27) für den Motoranschluss verbindbar sind.

13. Einrichtung nach den Ansprüchen 1 bis 12,
**dadurch gekennzeichnet,**
**dass** der Trennschalter (9) mittels einer Welle (34) und der Erdungsschalter (12) ebenfalls mittels einer Welle (35) von außen am Schaltschrank (2) betätigbar sind.

14. Einrichtung nach den Ansprüchen 12 und 13,
**dadurch gekennzeichnet,**
**dass** bei geöffnetem Trennschalter (9) und bei geschlossenem Erdungsschalter (12) und bei eingeschobener Isolierstoffplatte (9a) die Tür des Mittelspannungs-Raums (MS) öffenbar ist.
